(19)

Europäisches Patentamt

European Patent Office

Office européen des brevets

(11) **EP 1 884 578 A1**

(12) **EUROPEAN PATENT APPLICATION**

(43) Date of publication:
06.02.2008 Bulletin 2008/06

(51) Int Cl.:
*C25D 11/10* (2006.01)   *C25D 11/12* (2006.01)
*C25D 11/16* (2006.01)

(21) Application number: 06015912.6

(22) Date of filing: 31.07.2006

(84) Designated Contracting States:
AT BE BG CH CY CZ DE DK EE ES FI FR GB GR HU IE IS IT LI LT LU LV MC NL PL PT RO SE SI SK TR
Designated Extension States:
AL BA HR MK YU

(71) Applicant: MPG Max-Planck-Gesellschaft zur Förderung der Wissenschaften e.V.
80539 München (DE)

(72) Inventors:
• Lee, Woo, Dr.
06120 Halle (Saale) (DE)

• Nielsch, Kornelius, Dr.
10717 Berlin (DE)
• Gösele, Ulrich, Prof. Dr.
06114 Halle (Saale) (DE)
• Ji, Ran
06124 Halle (Saale) (DE)

(74) Representative: Manitz, Gerhart
Manitz, Finsterwald & Partner GbR
Postfach 31 02 20
80102 München (DE)

(54) **A method of manufacturing a self-ordered porous structure of aluminium oxide, a nanoporous article and a nano object**

(57)    A new oxalic acid based anodization process for long-range ordered alumina membranes has been developed, which can readily be implemented in nanotechnology as well as in industry. The process is a new generation of the so-called "hard anodization (HA)" that has widely been employed in industry for high-speed fabrication of mechanically robust, very thick (>100 $\mu$m) and low-porosity anodic alumina films since the 1960s. It offers big advantages over conventional anodization processes for nanoporous alumina membranes in terms of processing time, enabling 2500-3500% faster oxide growth with improved ordering of the nanopores. Perfectly ordered anodic alumina membranes on a cm$^2$-scale with a high aspect ratio (>1000) of uniform nanopores with periodically modulated diameters have been realized by this new anodization process.

FIG. 4

**Description**

The present invention relates to a method of manufacturing a self-ordered porous structure of $Al_2O_3$ with regularly spaced pores and regularly sized pores by inserting a piece of aluminium as an anode in an electrolytic cell, the cell also comprising a cathode and an electrolyte, and applying a potential difference between the anode and the cathode, with the electrolyte and the potential difference being selected to generate the desired self-ordered porous structure. In addition, the present invention relates to a nanoporous article of $Al_2O_3$ and to a nano object.

Methods of the above named kind have been used for the manufacture of nanoporous anodic aluminium oxide (AAO) with ordered hexagonal arrays of uniform parallel nanopores. The arrays have been intensively utilized as a template material for various functional nanostructures. In this connection, reference can be made to the following journal articles: S. B. Lee et al., Science 296, 2198 (2002), S. Park, J.-H. Lim, S.-W. Chung, C. A. Mirkin, Science 303, 348 (2004), N. I. Kovtyukhova, T. E. Mallouk, Adv. Mater. 17, 187 (2005), L. Zhi, J. Wu, J. Li, U. Kolb, K. Müllen, Angew. Chem. Int. Ed. 44, 2120 (2005) and I. Mikulskas, S. Juodkazis, R. Tomasiumas, J. G. Dumas, Adv. Mater. 13, 1574 (2001). These articles followed the discovery of Masuda and Fukuda of self-ordered alumina membranes in 1995 described in the paper by H. Masuda, K. Fukuda, in Science 268, 1466 (1995). In general, self-ordered $Al_2O_3$ pore arrays, fabricated under conventional so-called "mild anodization (MA)" conditions, require several days of processing time and the self-ordering phenomenon occurs only in narrow process windows, termed the "self-ordering regime". Due to the slow oxide growth rates (e.g. 2 to 6 $\mu$m/h), MA processes based on Masuda's approach have not been utilized in industrial processes so far. For practical applications, a simple and fast fabrication of highly ordered AAO with a wide range of pore sizes and interpore distances would be highly desirable.

In typical MA processes, self-ordered arrays of alumina nanopores can be obtained within three well-known growth regimes; i) using sulphuric acid ($H_2SO_4$) as an electrolyte at 25 V for an interpore distance ($D_{int}$) = 63 nm (see H. Masuda, F. Hasegwa, S. Ono, J. Electrochem. Soc 144, L127 (1997) and A. P. Li, F. Müller, A. Birner, K. Nielsch, U. Gösele, J. Appl. Phys. 84, 6023 (1998)), ii) using oxalic acid ($H_2C_2O_4$) as an electrolyte at 40 V for an interpore distance $D_{int}$ = 100 nm (see H. Masuda, K. Fukuda, in Science 268, 1466 (1995), A. P. Li, F. Müller, A. Birner, K. Nielsch, U. Gösele, J. Appl. Phys. 84, 6023 (1998) and F. Li, L. Zhang, R. M. Metzger, Chem. Mater. 10, 2470 (1998)), and iii) using phosphoric acid ($H_3PO_4$) as an electrolyte at 195 V for an interpore distance $D_{int}$ = 500 nm (see H. Masuda, K. Yada, A. Osaka, Jpn. J. Appl. Phys. 37, L1340 (1998) and K. Nielsch, J. Choi, K. Schwirn, R. B. Wehrspohn, U. Gösele, Nano Lett. 2, 677 (2002). When the anodization is carried out outside the self-ordering regime, the degree of spatial order decreases drastically. Applied voltages higher than the optimum value required to maintain stable anodization in a given electrolyte have hitherto always resulted in "breakdown" or "burning" of the oxide film caused by catastrophic flow of electric current (see S. Ono, M. Saito, M. Ishiguro, H. Asoh, J. Electrochem. Soc 151, B473 (2004)). These process limitations reduce the potential applications of nanoporous alumina. Substantial effort has been made by the present inventors to discover a new self-ordering regime in a wider range of Dint. For further background information, reference can be made to the following papers:

S. Shingubara, K. Morimoto, H. Sakaue, T. Takahagi, Electrochem. Solidstate Lett. 7, E15 (2004), S. Z. Chu, K. Wada, S. Inoue, M. Isogai, A. Yasumori, Adv. Mater. 17, 2115 (2005) and S. Ono, M. Saito, H. Asoh, Electrochim. Acta 51, 827 (2005). A combination of surface prepatterning of aluminium and subsequent MA has provided some degree of flexibility in controlling $D_{int}$ (see for example the following papers: I. Mikulskas, S. Juodkazis, R. Tomasiumas, J. G. Dumas, Adv. Mater. 13, 1574 (2001), H. Masuda et al., Adv. Mater. 13, 189 (2001), S. Fournier-Bidoz, V. Kitaev, D. Routkevitch, I. Manners, G. A. Ozin, Adv. Mater. 16, 2193 (2004) and H. Asoh, K. Nishio, M. Nakao, T. Tamamura, H. Masuda, J. Electrochem. Soc. 148, B152 (2001)). However, this MA-based approach has also fundamental limitations such that AAO membranes with a high aspect ratio (depth divided by the diameter) of nanopores above about 20 cannot readily be fabricated.

It is the object of the present invention to propose a method of manufacturing a self-ordered porous structure of $Al_2O_3$ which results in regularly spaced pores and regularly sized pores with an increased interpore separation typically in the range 150 to 400 nm, with it being possible to manufacture the porous structure much more quickly than has hitherto been possible for known prior art self-ordered porous structures and with aspect ratios of the pores, i.e. ratios of the length of the pores to the diameter of the pores being possible, greatly in excess of 20, for example of 50 or substantially more.

In order to satisfy this object there is provided a method of the initially named kind which is characterised in that the electrolyte is selected to be oxalic acid and the potential difference is selected to be constant within the range 80V to 180V and especially within the range from 120V to 150V. It has surprisingly been found that using the regime of the present invention pores can be grown with a very high aspect ratio significantly better than 50:1, and indeed at a high rate of 50 to 100 $\mu$m/h. Moreover, the spacing of the pores in the porous structure lies in the range from typically 150 to 400 nm, especially 220 to 300 nm, which is considerably larger than the previous interpore spacings observed, and particularly beneficial for some applications, such as use in a magnetic memory in which the pores are filled with a ferromagnetic material. By increasing the separation between the pores, the danger of crosstalk between the pores can be avoided. The oxalic acid which is used preferably has a concentration in the range from 1 molecular mass to 0.5 M.

Moreover, there is a linear relationship between the voltage that is applied and the interpore distance.

The method of the present invention could be considered a further development of the so-called "hard anodization (HA)" process, which was pioneered in the early 1960s (see for example E. Lichtenberger-Bajza, A. Domony, P. Csokán, Werkst. u. Korr. 11, 701 (1960), P. Csokán, Metalloberfl. 15, B49 (1961) and P. Csokán, C. C. Sc., Electroplat. Metal Fi. 15, 75 (1962)). The HA process has widely been utilized for various industrial applications (e.g., surface finishing of aluminium cooking wares) by taking advantage of the high-speed oxide growth (50 to 100 $\mu$m/h). In academic research, however, HA processes have been out of focus in the past four decades and have not been used for the development of nanostructured materials.

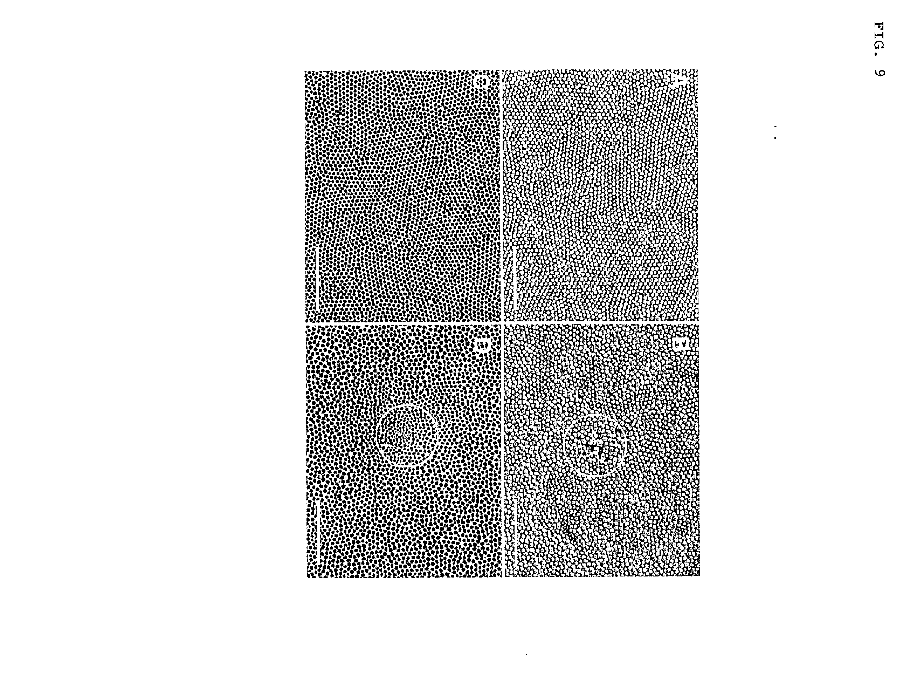

For suppressing breakdown and enabling uniform oxide film growth at a high voltage (> 100 V) it has been found beneficial, in accordance with the present invention, to provide an oxide layer (thickness > 300 nm, especially > 400nm, but preferably not greater than 1 $\mu$m) on the surface of the aluminium substrate prior to performing the method of the invention. This protective oxide layer can be generated by anodizing an aluminium substrate under MA conditions using, e.g., 0.3 M oxalic acid at 40 V for 5 to 10 min. Subsequently, the anodization voltage is slowly increased to a target formation voltage (80 - 180 V) for the method of the invention at the rate of 0.5 - 0.9 V/min and this method is then continued at a constant potential. It is believed that the surface oxide layer provides uniform pore nucleation sites at the early stage of high voltage anodization, preventing local electrochemical events such as local flow of high electrical current and defects by surface pitting such as will later be explained with reference to Fig. 9. The method of the invention is accompanied by a large evolution of heat, which should effectively be removed by using an appropriate electrochemical setup with adequate cooling of the piece of aluminium.

With regard to the current density which is used, this is preferably simultaneously controlled during the generation of the self-ordered porous structure to lie between 20 mA/cm$^2$ to 500 mA/cm$^2$ and preferably in the range from 100 to 200 mA/cm$^2$. Current densities below 20 mA/cm$^2$ result in the process being too slow, whereas current densities above 500 mA/ cm$^2$ tend to lead to breakdown of the process.

The current density may be kept constant or varied in accordance with a preset pattern.

More specifically, the current density is regulated by regulating at least one of the molar concentration of the electrolyte, the temperature of the electrolyte and the temperature of the piece of aluminium.

The temperature of the electrolyte is preferably selected to lie in the range -30°C to +80°C, optionally by adding an organic solvent to prevent freezing, such as an alcohol, for example ethanol, methanol, isopropanol, or an antifreeze such as ethylene glycol, or to lie in a temperature up to or even above 80°C by suppressing the boiling point of the electrolyte if necessary, for example by pressurization.

The above described methods make it possible to generate self-ordered nanopore structures at a fast growth rate with regularly spaced and regularly sized pores and pore aspect ratios of 50 and above, indeed pore aspect ratios of 700 to 1000 and higher can easily be achieved.

The method of the invention can also comprise the further step of treating an Al$_2$O$_3$ layer formed on the piece of aluminium lithographically to generate a regular periodic structure at a surface of the Al$_2$O$_3$ layer with a periodicity matched to that of the self-ordered porous structure.

Using this technique, the regularity of the spacing of the pores of the array can be positively influenced.

The lithographic treatment step can comprise one of an imprint step to produce a periodic array of indentations in either the Al$_2$O$_3$ layer or in a polymeric layer or photoresist layer provided on a surface of the Al$_2$O$_3$ layer, a soft imprint step as used in the manufacture of semiconductor chips, for example an S-FIL process; patterning of a photoresist layer, for example by photolithography, interference lithography, electronic beam lithography, focussed ion beam lithography or X-ray lithography, direct mask lithography, shadow mask lithography, for example by sputtering Al$_2$O$_3$ onto said surface through a shadow mask, and print lithography, i.e. depositing a patterned layer by a printing technique.

The periodicity of the lithographically generated structure is related to that of a self-ordered array, which arises without lithography such that dimensions of the generated array are smaller than corresponding dimensions of the lithographically generated structure by a geometrically defined factor. E.g. for a hexagonal array as a lithographically generated structure the spacing between pores of the generated array can be $D_{int}/3^{1/2}$; $D_{int}/9^{1/2}$; $D_{int}/27^{1/2}$ or more generally $D_{int}/(3n^2)^{1/2}$ where $D_{int}$ is the interpore spacing of a self-ordered array and n is an integer. This sort of spacing of the pores of the generated array arises when the lithographically generated structure is an array made up of equilateral triangles, e.g. having a corner point at the centre of each cell of the hexagonal array of a self ordered structure. In this case a further pore will, e.g., be generated at the centre of each triangle.

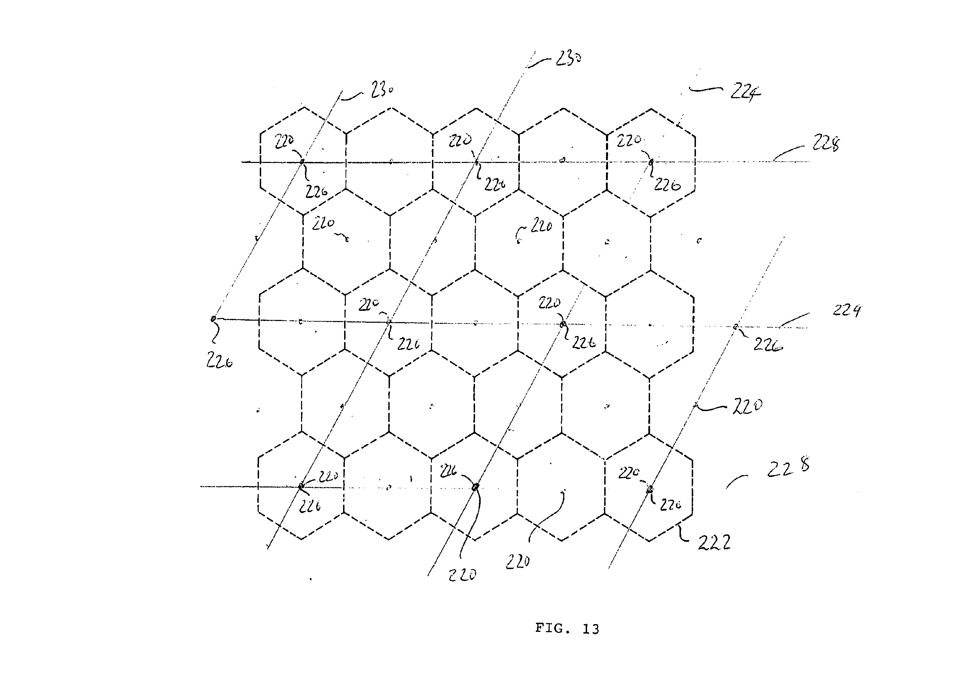

In an alternative lithographically generated structure, e.g. in the form of an array with diamond shaped cells (e.g. as shown in Fig. 13), the lithographically generated structure can have side lengths of the cells which amount to an integral multiple of the side lengths of the array of the self-ordered pores, i.e. of the pores of the generated array. This means that the generated array can be made with pore spacings smaller than for the naturally self ordered array.

This advantage also applies to the generated arrays which have dimensions smaller than the lithographically generated structure by a geometrical factor, i.e. for example the triangular array discussed in the immediately preceding paragraph.

In other words the self-ordered structure is guided lithographically to form with a periodicity related to, but smaller or larger than that of the structure of lithographically defined periodicity. Generally, the periodicity of the self-ordered structure is within $\pm$ 25 % of the structure of lithographically defined periodicity.

The self-ordered array is generally a hexagonal array and the lithographically matched array is a regular array having points corresponding to at least some of the corner points of the hexagonal self-ordered array, whereby pores arise not just at said corresponding points, but at regularly spaced intervals between said corresponding points.

The lithographically generated structure can also include elongate structures, with pores being formed at at least each end of each elongate structure.

Said piece of aluminium can comprise an aluminium film deposited on, or formed on, or bonded to a substrate selected from the group comprising an insulating substrate, such as glass or silicon dioxide, and a semiconducting or conducting substrate, such as ITO (Indium Tin Oxide), or silicon, or doped silicon.

When using an aluminium film or layer deposited on, or formed on, or bonded to a substrate, it is also possible to pattern the substrate lithographically to generate a regular periodic structure at the surface, with a periodicity matched to that of the self-ordered porous structure to produce patterning of the aluminium film or layer.

In this case the substrate is removed from the aluminium film or layer after patterning and prior to anodization.

As mentioned earlier, a surface layer of the piece of aluminium is preferably anodized prior to generation of the porous structure. This can be done after, or prior to, patterning thereof.

In accordance with a very important aspect of the invention, the method is modified so that, in addition to the step of generation of the self-ordered porous structure, one or more further anodization steps are carried out under different conditions to form pore segments of one or more different diameters at one or more positions along the length of each pore.

The said different conditions are preferably selected to correspond with the self-ordered porous structure at the same pore spacing, for example by selecting at least one of a different electrolyte and a different potential difference, a different current density (for example by varying the temperature of the electrolyte or of the concentration of the electrolyte), or by selecting the same electrolyte and the same potential difference, and varying the current density.

This technique allows each pore to have sections of different diameter along its length which can facilitate a variety of different uses. For example, the larger diameter portions can be regarded as interconnected chambers along the length of the pore. Alternatively, the pores can be partially or wholly filled with material to generate nano objects with thicker and narrower diameter portions or segments which, for example, could represent a nano-scale barcode. The structure can be used as a detector or as a photronic element. The material around the filled pores can be removed, e.g. by etching to leave just the solid (or hollow) nanostructures.

One aspect of the invention also comprises a method of manufacturing a self-ordered porous structure of $Al_2O_3$ with regularly spaced pores and regularly sized pores by inserting a piece of aluminium as an anode in an electrolytic cell, the cell also comprising a cathode and an electrolyte, and applying a potential difference between the anode and the cathode, with the electrolyte and the potential difference being selected to generate the desired self-ordered porous structure, the method being characterised by the further step of treating the piece of aluminium or an $Al_2O_3$ layer formed on the piece of aluminium lithographically to generate a regular periodic structure at a surface of the piece of aluminium or $Al_2O_3$ layer, with a periodicity matched to that of the self-ordered porous structure. This concept recognises that the lithographically structured periodic structure can be used with all known self-ordered porous nanostructured arrays.

For this, the electrolyte and the potential difference are selected from at least one of the following groups:

- sulphuric acid as electrolyte with a potential difference in the range from 40V to 90V to generate an interpore separation of 90-140 nm
- oxalic acid as an electrolyte with a potential difference of approximately 40V to obtain an interpore separation of 100 nm
- phosphoric acid as an electrolyte with a potential difference of 150V to 400V to obtain an interpore separation of 405 to 500 nm
- oxalic acid as an electrolyte with a potential difference in the range from 80V to 180V to obtain an interpore separation of 150 to 400 nm.

When used with a lithographically pre-patterned piece of aluminium or aluminium substrate, one of the following electrolytes is preferably used:

- malonic acid from 1 mM to 5 M and 70 to 180 V potential
- sulphuric acid from 1 mM to 5 M and 30 to 70 V potential
- phosphoric acid from 1 mM to 5 M and 200 to 500 V potential, wherein the pre-patterning fits the pore structure; i.e.

one pore per pre-patterned indentation, the interpore distance being in the range from 1.5 to 2.2 nm/V of the applied potential. These are other examples of hard anodization in accordance with the present invention.

The methods described above, can, as suggested, also include the further step of applying a coating to the walls of the porous structure to reduce the size of the pores. This coating can be used to modify the porous structure so that it operates as a chemical sensor or has other desired optical, electronic, physical, chemical, or biochemical properties, or simply to narrow the pore size to a specific level, for example for use as a filter.

The step of applying a coating to the walls of the pores of the pore structure can, e.g., comprise one of an electroplating step, infiltration of the pores with a liquid polymer and curing said liquid polymer with radiation, ALD (Atomic Layer Deposition) from a gas phase precursor, a CVD process, electroless deposition, and liquid phase deposition by use of a metal precursor, sol-gel coating, or layer-by-layer (LBL) assembly of a polyelectrolyte.

The above methods can also comprise the further step of removing the $Al_2O_3$ to leave the coating in the pores in the form of nanowires or nanotubes.

The pores of said porous structure can have portions of at least two different diameters so that the coating, which remains as a nanowire or a nanotube following the removal of the $Al_2O_3$, has correspondingly sized segments of larger and smaller diameters.

Self-ordered porous structures produced in accordance with any one of the preceding methods can be used for at least one of the following purposes: for magnetic data storage, as a detector, as a photonic device, as a filter, as a thermoelectric device, as a chemical reactor or as a membrane. When the nanoporous article has the form of a membrane it is conveniently obtained by forming a nanoporous alumina film on an aluminium substrate by anodization, subsequently removing the aluminium substrate and a barrier oxide layer sealing the nanoporous alumina film leaving a nanoporous alumina film with through-going channels. Such membranes can be used for various applications such as filters, templates for nano-fabrication and filters.

The invention also contemplates a nanoporous article of $Al_2O_3$ having a self-ordered porous structure of $Al_2O_3$ with regularly spaced pores and regularly sized pores, characterised in that the interpore spacing lies in the range from 150 to 400 nm.

A nanoporous article in accordance with the present teaching can readily be realised in which each said pore has an aspect ratio, being the ratio of the length of pores to the diameter of the pore, of at least 50.

A nanoporous article of the above kind will typically include residual carbon atoms of at least 1 % by weight, said carbon atoms being included in the walls of the pores.

The invention also contemplates, as mentioned above, a nanoporous article, wherein each pore has at least one segment of larger diameter and at least one segment of smaller diameter, with a difference between the larger diameter and the smaller diameter being at least 10 nm.

The nanoporous article can further comprise a coating formed on a wall of the or each pore.

More specifically, by filling the pores of a nanoporous article in accordance with the present invention, either partly or fully, a nano object can be created comprising at least first and second portions having different diameters in the range from 5 nm to 400 nm and an overall length of 200 nm to 1 mm or more, each portion having a length in the range from 100 nm to 50 $\mu$m, with the nano object being tubular or solid depending on the extent to which the pores are filled.

After forming such nano objects, they can be coated with a single layer of material, or with a multilayer structure to form a coated nanotube or core shell optionally with a different coating layer composition in the radial direction, said nano object being utilisable by way of example as a chemical reactor for one or more materials in the gas phase and/or in the liquid phase, in a solar cell or as a transparent electrode.

The present invention will now be described in more detail by way of example only and with reference to the accompanying drawings , which show:

Fig. 1              a schematic diagram illustrating an electrolytic cell for the production of self-ordered porous $Al_2O_3$ in accordance with the present invention,

Figs. 2A, 2B and 2C     diagrams to show the difference in speed of operation of prior art mild anodization processes in comparison to the special hard anodization process of the present invention,

Figs. 3A, 3B            the effect of voltage on a self-ordered anodized aluminium oxide under the conditions of the present invention and the dependency of parameters such as the interpore distance, the pore diameter and the porosity on the voltage used,

Fig. 4              a diagrammatic summary of self-ordering voltages and corresponding interpore distances under various conditions,

Fig. 5A, 5B          graphs respectively showing the content of water and carbon in anodized aluminium membranes prepared at different anodization voltages,

Fig. 6              a graph illustrating the average interpore distance $D_{int}$ as a function of the anodization time during anodization in accordance with the present invention, using 0.3 $MH_2C_2O_4$ at 1°C and at 140 V,

Fig. 7A-7F          a schematic illustration of one way of carrying out the method of the present invention, with Figs. 7B-7F being SEM micrographs illustrating the result of the process of the invention,

Figs. 8A-8G         drawings similar to Figs. 7A-7F but showing the further possibility of fabricating porous alumina with modulated pore diameters by a combination of mild and hard anodization of a prepatterned aluminium substrate,

Figs. 9A-9D         the effect of a thin porous oxide layer formed on the surface of the aluminium substrate prior to anodization in accordance with the present invention,

Fig. 10             the evolution of the oxide film thickness as a function of time during anodization in accordance with the present invention at a high voltage and during mild anodization at a low voltage,

Figs. 11A-11C       nano objects in accordance with the present invention which are produced in accordance with the present invention,

Figs. 12A-12C       further representations of nano objects similar to those shown in Figs. 11A-11C, but with another shape and

Fig. 13             a diagram illustrating one possibility of carrying out lithographically guided etching in accordance with the present invention.

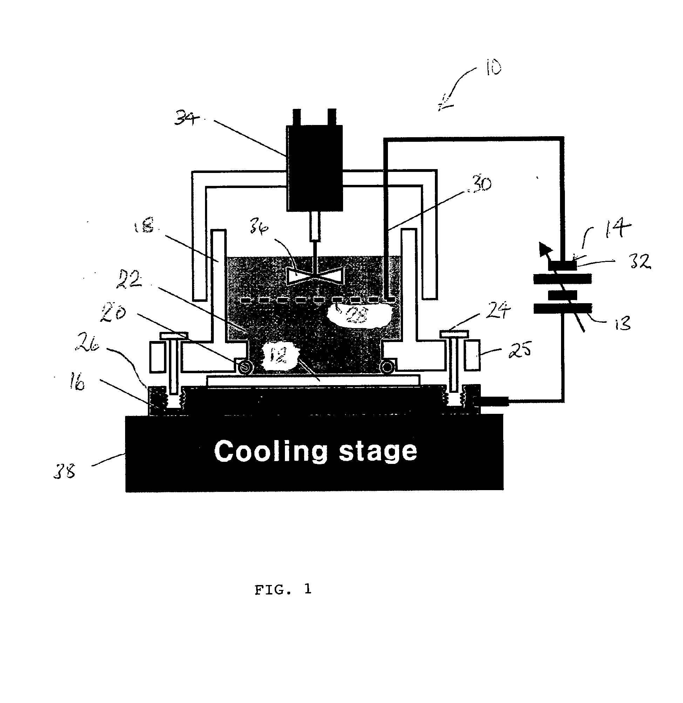

Turning now to Fig. 1 there can be seen an electrolytic cell 10 suitable for use, in accordance with the present invention, to manufacture a self-ordered, porous structure of $Al_2O_3$ with regularly spaced pores and regularly sized pores. A piece of aluminium 12 forms an anode in the electrolytic cell and is connected to the anode 13 of a power source, schematically illustrated as a battery with variable potential 14, which is actually connected to a copper plate mounted immediately beneath the piece of aluminium or aluminium substrate 12. The electrolytic cell includes a housing 18 of insulating material such as PTFE (Teflon$^{RTM}$) which is actually open at the bottom and sealed relative to the piece of aluminium 12 via an O-ring 20. The O-ring is held under compression to prevent the escape of the electrolyte 22 by means of bolts 24 which engage through the flange 25 of the housing 18 into bores 26 provided in the copper plate 16.

Contained in the cell, in juxtaposition with the piece of aluminium, is a cathode in the form of a platinum mesh 28 which is connected via the lead 30 to the negative terminal 32 of the variable DC voltage source 14. The voltage source will normally be a regulated power supply, with a means for varying the voltage and a monitor for it, so that any deviation of the voltage from the included set level is automatically corrected and regulated to the desired level.

Supported on the top of the electrolytic cell is a stirrer 34 with stirrer rotor 36 which serves to keep the electrolyte in the electrolytic cell moving which, on the one hand, ensures a uniform temperature throughout the electrolyte and, on the other hand, helps keep the concentration of the electrolyte at the piece of aluminium 12 substantially constant.

Mounted beneath the copper plate 16 is a cooling stage 38 which serves to extract heat from the copper plate and thus from the piece of aluminium 12. This design recognises that there is considerable heat generation at the piece of aluminium 12 during the process and provides one way of keeping the piece of aluminium, and thus also the electrolyte, at a substantially constant temperature which is important to ensure the desired performance of the method.

This is of course not the only possible design. In an industrial environment the electrolyte could, for example, continuously flow into and out of the electrolytic cell and could pass through concentration and temperature monitoring devices which operate control and regulation devices to maintain the concentration of the electrolyte and the temperature substantially constant.

If the piece of aluminium is mounted on a substrate, such as an insulating or semiconducting substrate, then it needs to be contacted differently to the anode of the variable potential DC source. This can, for example, be done at an exposed part of the aluminium surface outside of the electrolytic cell 10, for example at an annular region of the piece of aluminium 12 radially outside of the O-ring 20 in a design involving an O-ring. There is of course also no reason why the base of the electrolytic cell should not be closed and the piece of aluminium mounted inside the electrolytic cell which would dispense with the need for an O-ring, but would require a different arrangement to ensure adequate temperature control of the piece of aluminium and the electrolyte.

In the following, the expression "hard anodizing" or "HA" will be used as a short reference to the method of the present invention to distinguish it from mild anodization (MA), but should not be understood as meaning that the method of the invention is the same as the previously known hard ionization process, e.g. as previously utilized in industry to generate hard anodized coatings on commercial articles of aluminium.

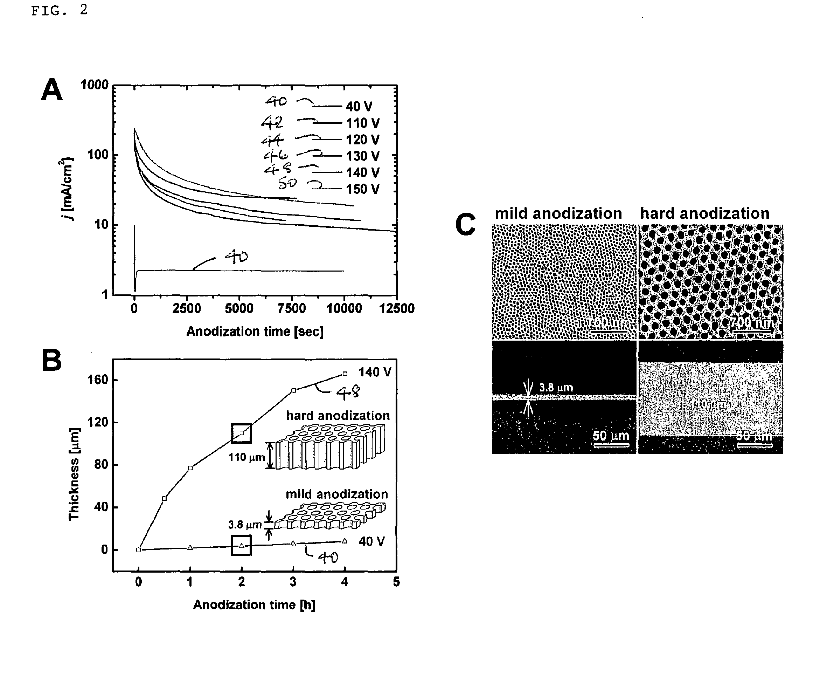

The evolution of the current and of the thickness of the AAO film were investigated for HA at 110 - 140 V and MA at 40 V using 0.3 M $H_2C_2O_4$ at 1°C. The pieces of aluminium used for these experiments are electropolised aluminium substrates: The results are shown in Fig. 1. Unlike the typical anodization curve for MA (line 40 in Fig. 2A) the current-time transients in HA at different voltages show a nearly exponential decrease as a function of time as shown by the lines 42, 44, 48 and 50 in Fig. 2A, Such an unusual evolution of the current for HA can be explained by the diffusion-limited electrochemical oxidation of aluminium at the pore bottom as the result of extremely rapid film growth (50 - 70 $\mu$m/h). It is believed that the anodization current is mainly related to the movement of ionic species ($O^{2-}$, OH-, $Al^{3+}$) through the oxide layer at the bottom of the pores. The mass transport of oxygen containing anionic species from the bulk reservoir (i.e., the electrolyte) to the oxide growth interfaces determines the current during the anodization process. Accordingly the ionic current is expected to gradually decrease over time due to the extended diffusion path along the nanopores. The diffusion-limited anodization during the HA process could be further evidenced by the non-linear film growth rate.

More specifically, Fig. 2B shows the film thickness as a function of time during HA at 140 V (line 48) and a MA process at 40 V (line 40). The different thicknesses of anodic oxides after two hours of anodization are highlighted schematically in the insets in Figs. 2A and 2B. Fig. 2C shows SEM micrographs of the corresponding AAO specimens formed by MA for 2h (left column) and HA for 2h (right column). The arrangements of pores for the respective samples are shown in the upper SEM micrographs. The thicknesses of the respective samples are indicated in the cross-sectional SEM micrographs.

The HA process offers a big advantage over conventional anodization processes in terms of much lower fabrication times due to the high-speed film growth rate (Fig. 2C).

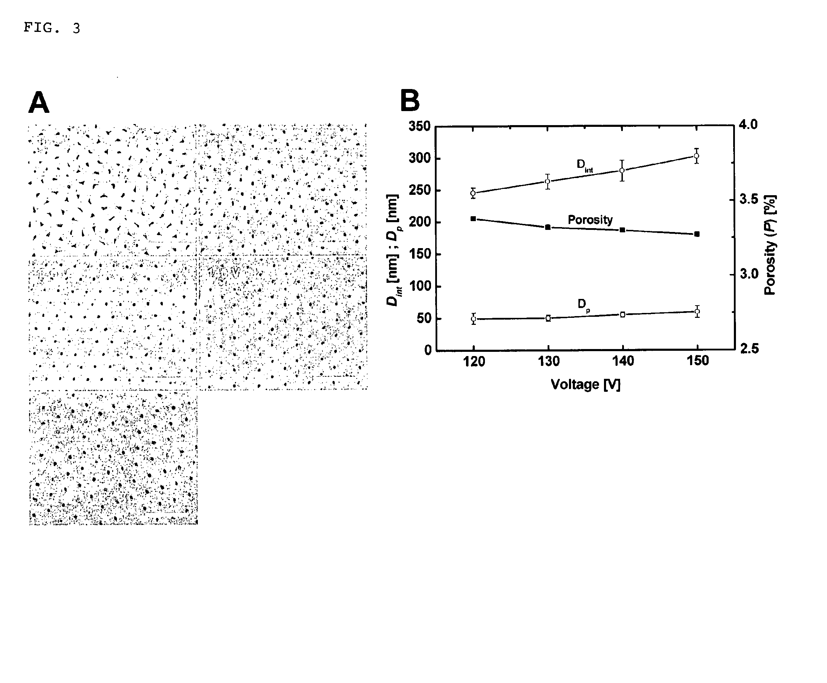

Reference will now be made to Figs. 3A and 3B. Fig. 3A shows the effect of voltage on the self-ordering of anodic aluminium oxide (AAO) by way of surface SEM micrographs of self-ordered AAOs formed in hard anodization (HA) at voltages specified in the respective micrographs (scale bars = 800 nm). HA of mirror-finished aluminium substrates was performed using 0.3 M $H_2C_2O_4$ at 1°C for 160 min. SEM investigation was performed on the bottom surfaces of the resulting AAOs after the removal of the barrier layer by ion milling. Fig. 3B shows the evolution of interpore distance ($D_{int}$), pore diameter (Dp) and porosity (P) as a function of the HA voltage. The porosity (P) of AAO was estimated by using the following equation assuming an ideal hexagonal arrangement of the pores; $P = \dfrac{\pi}{2\sqrt{3}}\left(\dfrac{D_p}{D_{int}}\right)^2$, where

$D_p$ and $D_{int}$ denote the pore diameter and the interpore distance (or cell size), respectively.

Investigations of the pore arrangement have revealed that the cell homogeneity of AAO films increases dramatically as soon as the anodization voltage is higher than 110 V (Fig. 3A). The most highly ordered AAO films were obtained under 120 - 150 V, where the cell ordering is insensitive to the anodization potential. According to SEM analyses, the typical size of ordered domains turned out to be in the range of 6 - 8 $\mu$m. The degree of self-ordering of oxide nanopores decreased as the anodization potential was approaching 155 V, which is the maximum anodization voltage that could be applied avoiding breakdown.

The effects of anodization voltages on the self-ordering of the AAO films are shown in Fig. 3B. The interpore distance ($D_{int}$) and pore size ($D_p$) are found to be linearly proportional to the anodization voltage similar to the MA process. The porosity (P) of self-ordered anodic alumina films formed by HA is $P_{HA}$ = 3.3 - 3.4 %.

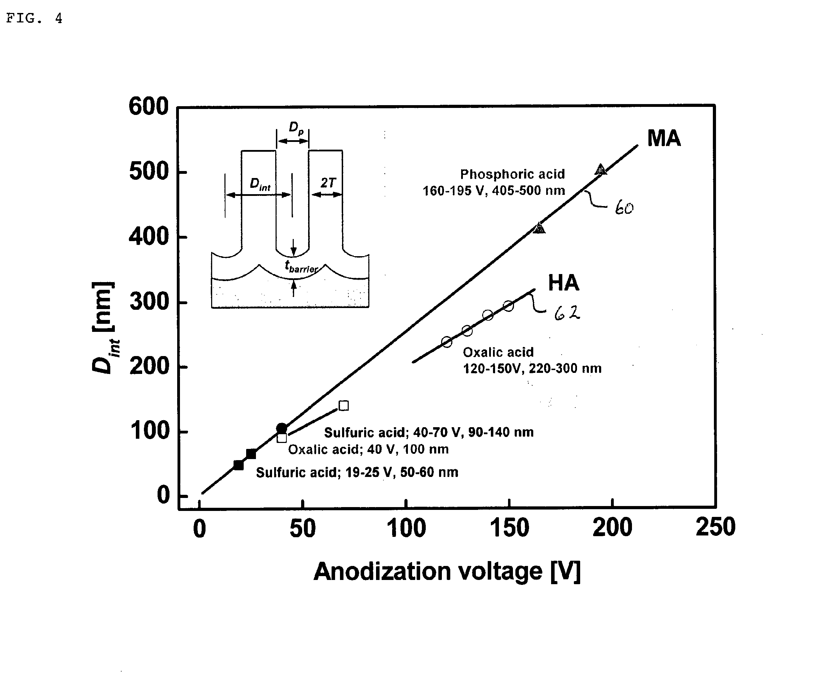

Figure 4 shows the relationship between the interpore distance $D_{int}$ and the anodization voltage for HA. The self-ordering voltages and the corresponding values of $D_{int}$ that have been reported for MA processes are also plotted for comparison. More specifically, Fig. 4 shows a summary of self-ordering voltages and corresponding interpore distance ($D_{int}$) in conventional mild anodization (MA) in sulphuric acid (filled black squares), oxalic acid (filled black circles) and phosphoric acid (filled black triangles), together with recently reported results by Chu et al. for sulphuric acid (open black squares). The black solid line 60 represents the linear regression of the data with a correlation parameter of $\zeta MA$ = 2.5 nm/V. The horizontal band for the interval 100 nm < $D_{int}$ < 400 nm represents the unexplored self-ordering regime until now. The interpore distance ($D_{int}$) vs. anodization voltage observed in oxalic acid under hard anodization conditions (HA) is plotted (using open circles) with the corresponding regression line 62 (black solid line). The correlation parameter estimated from the linear regression is $\zeta_{HA}$ = 2.0 nm/V. The inset shows the schematic diagram of a cross-section of the porous alumina structure with the barrier layer; $D_{int}$ = interpore distance, $D_p$ = pore diameter, $T$ = thickness of the pore wall, $t_{barrier}$ = thickness of the barrier layer.

It should be pointed out that the present HA process establishes a new self-ordering regime in the ranges of $D_{int}$ = 200 nm ~ 300 nm, filling the gap which has not been achieved by conventional MA processes. Previous studies indicate that of AAO formed under ordinary MA conditions using $H_2SO_4$, $H_2C_2O_4$, and $H_3PO_4$ is linearly dependent on the applied voltage with a proportionality constant $\zeta_{MA}$ = 2.5 nm/V as reported in J. P. O'Sullivan, G. C. Wood, Proc. R. Soc. London, Ser. A 317, 511 (1970), F. Keller, M. S. Hunter, D. L. Robinson, J. Electrochem. Soc 100, 411 (1953), K. Ebihara, H. Takahashi, M. Nagayama, J. Met. Finish. Soc. Jpn. 34, 548 (1983). However, the proportionality constant $\zeta_{HA}$ = 2.0 nm/V for AAO films formed by the HA process was found to be lower than for the MA processes. The reduced $\zeta$ for HA could be attributed to a reduced voltage dependence of the pore diameter $(D_p)$ and the barrier layer thickness $(t_{barrier})$ of anodic alumina under high current density (i.e., high electric field (E) at the pore bottom). The voltage dependence of $D_{int}$ can be expressed by $D_{int} = \zeta \cdot U = [C_{pore} + C_{wall} \cdot t_{barrier}] \cdot U$, where $C_{pore} \cdot U$ and $C_{wall} \cdot t_{barrier} \cdot U$ represent respectively the potential $(U)$ dependence of the pore diameter $(D_p = C_{pore} \cdot U)$ and the wall-thickness $(T = C_{wall} \cdot t_{barrier} \cdot U)$ of alumina nanopores with proportionality constants $C_{pore}$, $C_{wall}$ (see inset of Fig. 4).

According to microscopic analyses, the barrier layer thickness for HA increases at a rate of

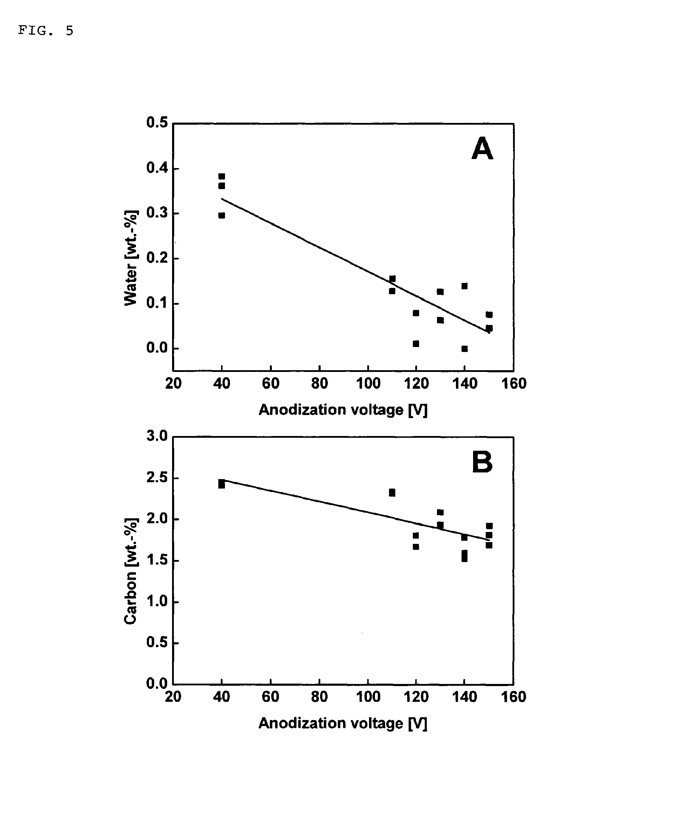

$$t_{barrier}^{HA} \sim 1.0 \text{ nm/V},$$ which is ~ 20 % smaller than $t_{barrier}^{MA} \sim 1.3 \text{ nm/V}$ for MA processes (see F. Keller, M. S. Hunter, D. L. Robinson, J. Electrochem. Soc 100, 411 (1953) and M. S. Hunter, P. Fowle, J. Electrochem. Soc 101, 481 (1954).). The reduced $t_{barrier}^{HA}$ could be attributed to the high current density $(j)$ involved in the HA process in accordance with the high field conductivity theory which is explained in A. Güntherschulze, H. Betz, Z. Phys. 92, 367 (1934) and N. Cabrera, N. F. Mott, Rept. Prog. Phys. 12, 163 (1948). For valve metals, the current density $(j)$ can be related to the potential drop $(\Delta U)$ across the anodic barrier layer of thickness $t_{barrier}$: $j = j_0 \cdot \exp(\beta \Delta U / t_{barrier})$, where $j_o$ and $\beta$ are material-dependent constants at a given temperature (31), and $\Delta U / t_{barrier}$ is the effective electric field strength $(E)$ across the barrier layer. Experiments related to the invention have shown there are differences in the chemical compositions of AAO films formed by HA and MA. This is illustrated in Figs. 5A and 5B which are graphs showing the contents of water and carbon in anodic alumina membranes prepared by hard anodization (HA at > 100 V and mild anodization (MA) at 40 V. According to quantitative analyses on carbon and water contents, hard anodized samples showed a lower level of impurities, which might explain the higher density of anodic alumina formed by the HA process. Table 1 below shows a comparison of typical parameters for mild anodization and hard anodization. As can be seen from Table 1, the main differences lie in the current density and the potential difference employed for anodization.

EP 1 884 578 A1

**Table 1.** Mild anodization (MA) vs. hard anodization (MA) in 0.3 M $H_2C_2O_4$ (1°C).

| | Mild Anodization (MA) | Hard Anodization (HA) |
|---|---|---|
| Voltage (V) | 40 | 110 - 150 |
| Current density (mA/cm$^2$) | 5 | 30 - 250 |
| Film growth rate ($\square$m/h) | 2.0 (linear) | 50 - 70 (nonlinear) |
| Porosity (P; %) | 10 | 3.3 - 3.4 |
| Interpore distance ($D_{int}$; nm) | 100 | 220 - 300 |
| Pore diameter ($D_p$; nm) | 40 | 49 - 59 |
| Pore density ($\square$; pores/cm$^2$)[a] | $1.0 \times 10^{10}$ | $1.3- 1.9 \times 10^9$ |
| $\square$ (nm/V)[b] | 2.5 | 2.0 |
| Water contents (wt.-%) | 0.3 - 0.4 | 0.1 |
| Carbon contents (wt.-%) | 2.4 | 1.8 |
| Density (g/cm$^3$) | 2.8 | 3.1 |

[a] [b] Proportionality constant correlating the interpore distance ($D_{int}$) of self-ordered anodic alumina with the anodization voltage.

$$\text{Pore density } (\rho) = \frac{2}{\sqrt{3}D_{int}^{\ 2}} \times 10^{14} \ cm^{-2}.$$

In addition, the differences in impurity levels could influence the electrical and optical properties of the anodic alumina films. In fact, the AAO films formed by HA (> 100 V) exhibited a bright yellow colour, whereas AAO films prepared by MA (40 V) are transparent.

For a given anodization potential, the barrier layer thickness $(t_{barrier})$ is inversely proportional to the logarithm of current density $(j)$.

Microscopic analyses indicated that the pore diameter $\left(D_p^{HA}\right)$ of anodic alumina for HA increases at a rate

of $C_{pore}^{HA} = 0.4 \text{ nm/V},$ which is 55 % lower than $C_{pore}^{MA} = 0.9 \text{ nm/V for MA.}$ For a given anodization potential, the HA process yields anodic alumina with smaller Dp. It is reported that Dp is affected strongly by the dissolution velocity of alumina that is determined by the pH value at the pore bottom. In this connection, reference can be made to the paper by V. P. Parkhutik, V. I. Shershulsky, J. Phys. D: Appl. Phys. 25, 1258 (1992). For HA, the reduced Dp could be explained by enhanced proton activity at the pore bottom, where significant Joule heating occurs as a result of the high current density (i.e., high electric field $E$).

It can be assumed that the rapid oxide formation due to the high current density will generate a high mechanical stress at the metal/oxide interface due to the associated volume expansion. This is suggested in the papers by J. P. O'Sullivan, G. C. Wood, Proc. R. Soc. London, Ser. A 317, 511 (1970) and O. Jessensky, F. Müller, U. Gösele, Appl. Phys. Lett. 72, 1173 (1998). Under this energetically unfavourable condition, the anodization will proceed in a way to minimize the resulting mechanical stress. This can be achieved by reducing the cell size in order to enlarge the surface area of the metal/oxide interface. The ion mobility within the barrier oxide and the degree of field-stimulated local oxide dissolution should be adjusted accordingly. Since the interfacial stress increases with the oxide growth rate at the metal/oxide interface, the size of cells should decrease with current density for a given anodization voltage. Therefore, $\zeta_{HA}$ for anodic alumina formed by HA should be smaller than that for AAO formed by MA. It is also expected that the high interfacial stress gives rise to a repulsive force between the pore cells at the barrier layer. It is proposed that, analogous to the case of MA, the repulsive interactions are the main driving force for the self-organized formation of the hexagonal pore arrays. In other words, the high current density in HA is the main factor determining the self-ordering of the oxide nanopores as well as the cell size.

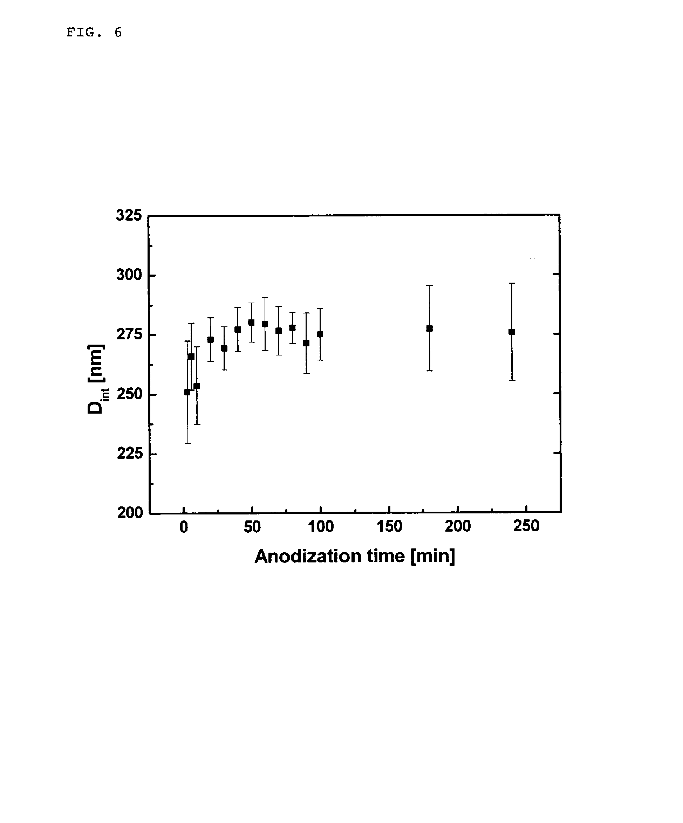

Since the current density decreases exponentially with time (Fig. 2A), it is expected that the cell size (or $D_{int}$) should increase with anodization time. Investigations of the evolution of $D_{int}$ as a function of anodization time at 140 V revealed that the average $D_{int}$ of the samples actually increases with anodization time for the first 30 min (Fig. 6). The initial increase in $D_{int}$ could be ascribed to the rapid drop in current density at the early stage of HA, and supports the idea that the current density (i.e., electric field strength E across the barrier layer at the pore bottom) is a key parameter governing $D_{int}$ in HA. On the other hand, the variation in the average $D_{int}$ was found to be insensitive to the anodization time for samples anodized for > 40 min, where the current density is rather stable (Fig. 6). All of these experimental findings suggest that the current density needs to be maintained at a certain level in order to obtain long-range ordered anodic alumina with a desired $D_{int}$ at a given anodization voltage.

The arguments raised above were further evidenced by realizing the fabrication of monodomain AAO membranes with a high aspect ratio of uniform nanopores by HA. For MA processes it is well established that a prepattering of the aluminium substrates prior to the anodization initiates pore nucleation and guides the growth of nanopores during anodization. AAO membranes with ideally ordered pore arrangement in a wide range of intervals could be prepared by this approach. However, the attainable maximum aspect ratio of the nanopores maintaining the initial periodic arrangement critically depends on the anodization conditions. Anodic alumina with a high aspect ratio of uniform nanopores can only be prepared within limited processing windows, satisfying self-ordering conditions. For MA of prepatterned aluminium using oxalic acid, high aspect ratios (> 1000) of the nanopores could be obtained at 40 V. Under other anodization voltages, the ideal ordering of the nanopores can only be maintained up to several micrometers in depth (aspect ratio < 20), and became perturbed as the thickness of the oxide increased.

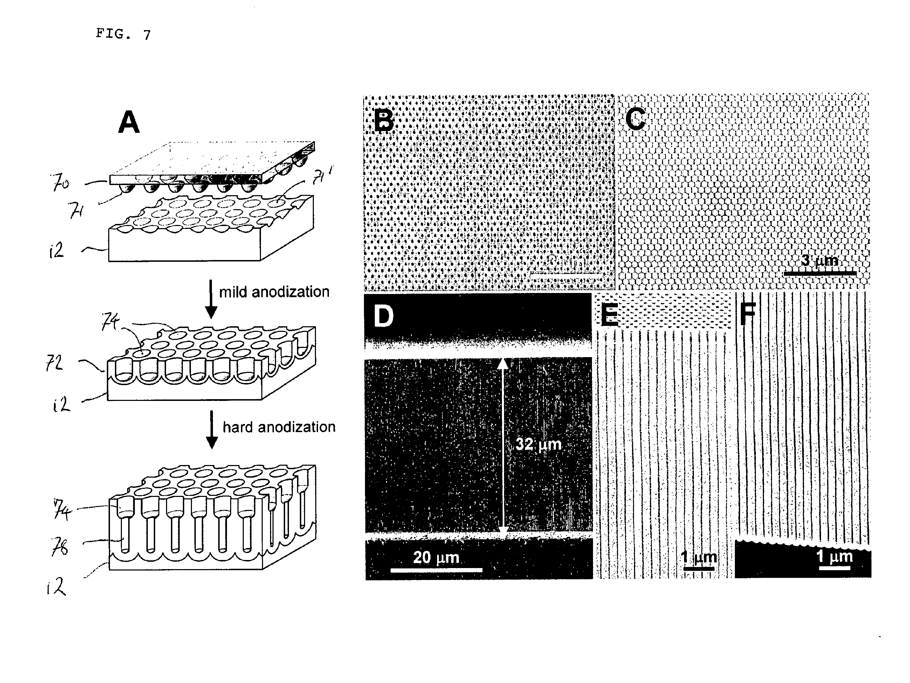

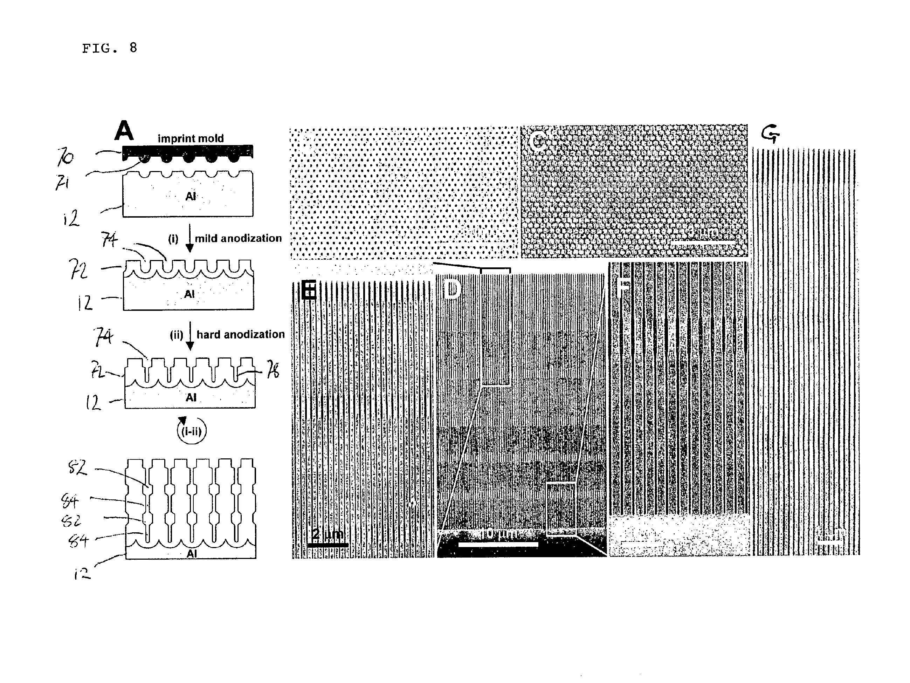

Investigations related to the invention are summarized in Figs. 7A to 7G and 8A to 8F. More specifically, Fig. 7A shows a scheme for the fabrication of ideally ordered anodic alumina membranes with high aspect ratio of uniform nanochannels by a combination of surface nanopatterning using a nickel imprint stamp 70 followed by a short period of mild anodization (MA) and then hard anodization (HA). The imprint stamp 70 is used to produce an ordered array of depressions in the piece of aluminium 12. The mild anodization anodizes the whole surface layer 72 of the piece of aluminium 12 and produces short regularly arranged pores such as 74 at the surface. The voltage is then increased to the level for hard anodization and long relatively narrow pores 78 are then produced from the base of each of the short pores 74. The imprint stamp 70 is selected in this example to have protrusions such as 71 arranged in an array corresponding to the self-ordered arrangement of the high aspect ratio pores 78 when grown under the appropriate HA conditions, as specified for example in Fig. 4, line 62.

Figs. 7B and 7C show SEM micrographs of the top and bottom surface, respectively, of the as-prepared anodic alumina. Figs. 7D to 7F show cross-sectional SEM micrographs of anodic alumina. The thickness of the anodic alumina prepared by HA for 30 min is indicated in Fig. 7D. The magnified cross-sectional views of the top and the bottom part of membrane, i.e. the cross-section taken in planes which include the longitudinal directions of the parallel pores, are shown in Figs. 7E to 7F, respectively. Figs. 8A to 8G are similar to Figs. 7A to 7F, but show in Fig. 8A a scheme for the fabrication of porous alumina with modulated pore diameters by alternating use of a combination of mild and hard anodization process i) and ii) on a prepatterned aluminum substrate 12. Figs. 8B and 8C show SEM micrographs of the top and bottom surface, respectively, of the as-prepared anodic alumina $(D_{int}$ = 275 nm) with perfect pore arrangement. Figs. 8D to 8F show SEM micrographs in cross-section view of the corresponding sample with modulated pore diameters, i.e. alternating pore segments 82, 84 with larger pore diameters and smaller pore diameters respectively. The magnified cross-section image of the top and bottom part of the membrane is shown in Figs. 8E and 8F, respectively. Fig. 8G shows a cross-section SEM micrograph of anodic alumina $(D_{int}$ = 210 nm) with high aspect ratio (> 700) of uniform nanopores. The cross-section is taken on a plane which includes the longitudinal axes of parallel pores of lying in a common plane. The nanopores are prepared by hard anodization on prepatterned aluminum $(D_{int}$ = 210 nm) conducted at 110 V in this case. A solution of 0.3 M $H_2C_2O_4$ (10°C) was used in order to obtain the desired current density $(j$ = 40 - 45 mA/cm$^2$).

The Figs. 7B to 7F and 8B to 8F show the highly ordered structures which can be produced using the present teaching, as well as the extremely high aspect ratio parallel pores which can be produced at a high production rate.

Thus, the investigations have shown that the HA of aluminium can overcome the limitations of MA with respect to the aspect ratio of the pores and the low production rate. AAO membranes with uniform nanopores with aspect ratios > 700 were prepared by HA in the broad self-ordered regime of oxalic acid (Fig. 8G). In addition, based on the fact that HA of aluminium yields anodic alumina with one-third lower porosity than MA (i.e., $P_{HA}$ ~ 3.3 % for HA and $P_{MA}$ ~ 10 % for MA), it proved possible to realize modulations in nanopore diameters by combining both anodization processes. This will now be explained further with reference to Figs. 8A to 8G. Initially, the surface of electropolished aluminium was prepatterned by using an imprint stamp with hexagonal arrays of imprint tips with 275 nm period (Fig. 8A). Subsequently, the resulting aluminium was anodized under MA condition at 110 V using 4 wt.-% $H_3PO_4$ (10°C) for 15 min, resulting in a segment of oxide nanopores with higher porosity. Subsequently, HA was carried out at 137 V using 0.015 M $H_2C_2O_4$ (0.5°C) for 2 min, resulting in a lower porosity nanopore segment. The same number of pores is present and $D_{int}$ is the same, but the pore diameter Dp is substantially smaller. At the same sample anodization potential difference (V), the pore diameter (Dp(HA)) in hard anodized alumina is about 55 % smaller than the pore diameter (Dp(MA)) in mild anodized alumina. The following equations apply: Dp (HA)) = 0.4 nm x V, $D_p$(MA) = 0.9 nm x V. . The narrower diameter pore segments are concentric to the associated larger diameter pore segments. During HA, the current density was maintained at the range of 33 - 35 mA/cm$^2$ by adding fresh 0.3 M $H_2C_2O_4$ into the anodization cell. The anodization voltage was chosen based on the linear relation between $D_{int}$ and the anodization voltage; $\zeta MA$ = 2.5 nm/V for MA and $\zeta HA$ = 2.0 nm/V for HA. These two anodization processes constitute one modulation period in the oxide nanopores. Highly uniform periodic modulations in pore diameters could be achieved by repeating two consecutive anodization processes (Figs. 8D-F). The length of each segment of oxide nanopores can freely be controlled by varying the anodization time of the respective anodization process. The maintenance of the ideal hexagonal arrangement (Fig. 8B) of nanopores was verified by SEM investigation of the bottom surface of the oxide membrane, showing the ideally ordered configuration of barrier layers (Fig. 8C). Anodic alumina with a high aspect ratio (> 1000) of uniform parallel nanopores $(D_{int}$ = 210 nm) could also be fabricated by a continuous HA process (Fig. 8G).

Finally, from a practical point of view the hard anodization (HA) process has many advantages over the conventional mild anodization (MA) as summarized in Table 1. It is believed these findings on the self-ordering phenomenon during HA will lead to a renaissance of HA processes in nanotechnology research as well as in industry. Major findings on HA with oxalic acid are as follows: (i) The current density (i.e., the electric field strength E at the pore bottom) is an important parameter governing the self-organization of oxide nanopores in a given anodization potential. (ii) A new self-ordering regime is established over a broad range of interpore distance $D_{int}$ = 220 to 300 nm. (iii) The ratio $\zeta$ between the interpore distances $D_{int}$ and the anodization potential is lower $(\zeta_{HA}$ = 2.0 nm/V for HA, $\zeta_{MA}$ = 2.5 nm/V for MA). (iv) The porosity P is lower $(P_{HA}$ ~ 3 %, $P_{MA}$ ~ 10 %). (v) The growth rate of the porous oxide film is 20 - 30 times larger (> 50 μm/h) than for MA. (vi) Ideally ordered alumina membranes with high aspect ratio (> 700) of uniform nanopores can be fabricated by HA of prepatterned aluminium. (vii) A combination of HA and MA allows to achieve a modulation of the diameter of oxide nanopores.

Figs. 9A to 9D show the effect of a thin porous oxide layer formed on the surface of the aluminium substrate prior to hard anodization (HA). SEM micrographs of the bottom surfaces of anodic alumina films are shown which are formed by HA of aluminium with a surface oxide layer (Fig. 9A) and without a surface oxide layer (Fig. 9B). Figs. 9C and 9D show SEM micrographs of aluminium surfaces of the respective samples after removal of the porous oxide layers. Scale bar = 4 μm. The sample prepared by HA of aluminium with a thin surface oxide layer shows long-range ordering of oxide cells as can be seen from Figs. 9A and 9C. However, direct HA of a surface-finished aluminium substrate results in a non-uniform oxide film, containing numerous defects as indicated by white circles in Figs. 9B and 9D. Anodization was conducted using 0.3 M $H_2C_2O_4$ (1°C) at 140 V for 40 min. After the anodization free-standing alumina membranes were obtained by removing the respective aluminium substrates using an aqueous mixture solution of $CuCl_2\cdot 2H_2O$ and HCl. On the other hand, textured surfaces of aluminium substrates were obtained by removing the respective anodic alumina films using a mixture solution of 1.6 wt. % chromic acid and 6 wt. % phosphoric acid at 65°C.

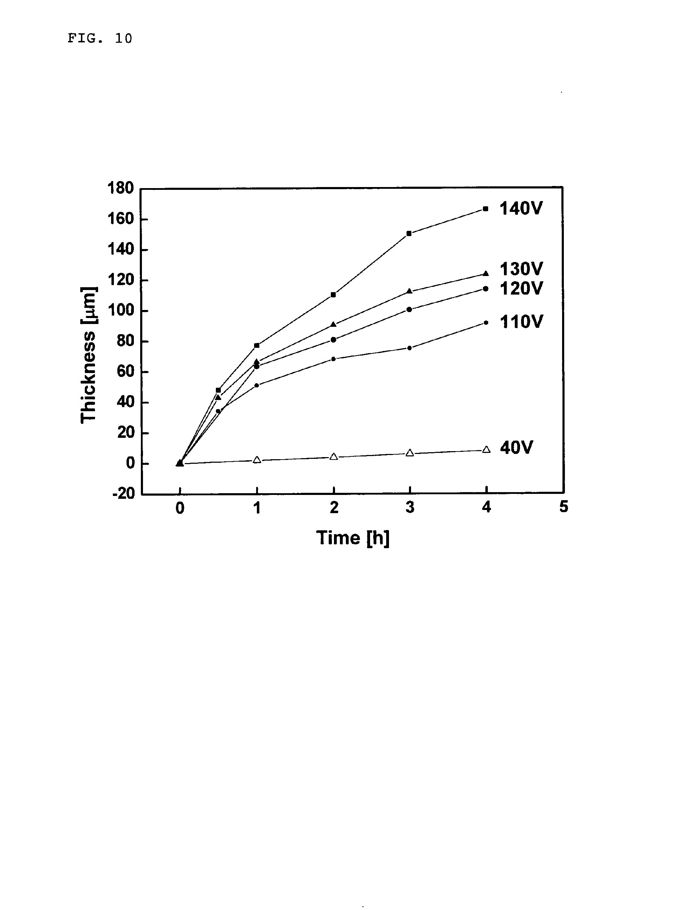

Fig. 10 illustrates the evolution of the oxide film thickness as a function of time during hard anodization (HA) at 110 - 140 V and mild anodization (MA) at 40 V. Both anodizations were performed using 0.3 M $H_2C_2O_4$ (1°C).

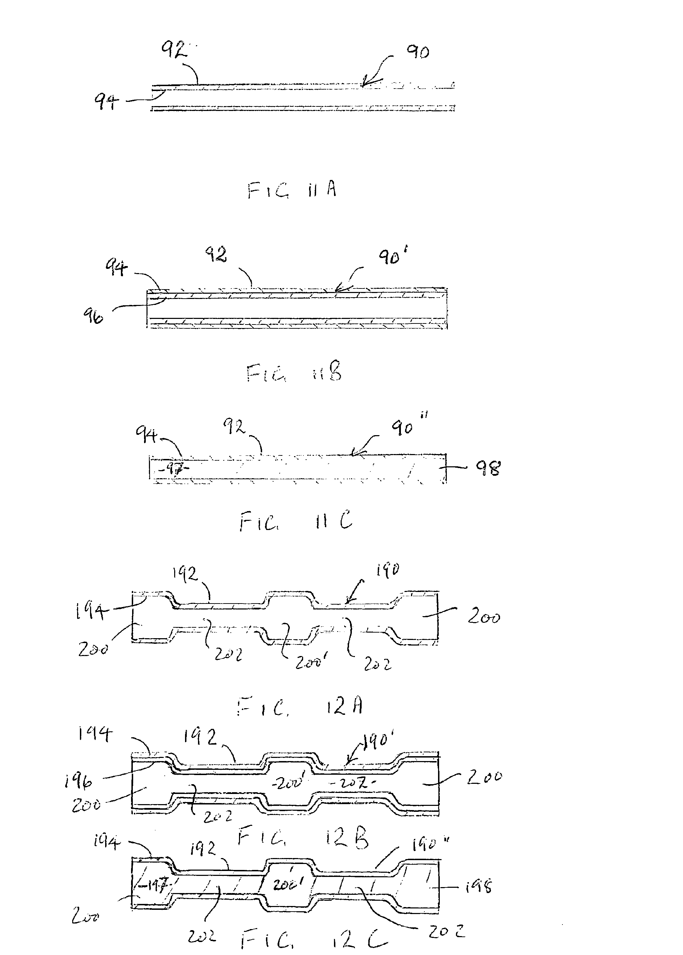

It has already been mentioned above that it is possible to coat the insides of the pores such as 74, 78 or 82, 84 to form either a tubular article in the form of a nanotube, if the coating is relatively thin, or if the pores are filled completely, a solid nano object. Thereafter the $Al_2O_3$ surrounding the pores can be etched away to leave either the coating of the pore as a nanotube or the pore itself as a nanobar. Fig. 11A shows a nanotube 90 produced in this way, that is to say the outside envelope 92 of the axial section of the nanotube 90 shown in Fig. 11A represents the interface to the internal wall of the pore in which the coating 94 was formed.

In Fig. 11A only a single coating 94 was provided on the inside wall of the pore, whereas in Fig. 11B first and second different coatings were provided resulting in a nanotube 90' similar to that shown in Fig. 11A but with a further coating 96 provided inside the hollow nanotube. The pore used to form the hollow nanotube 90' of Fig. 11B has a different diameter from that used to form the nanotube 90 of Fig. 11A. This is, however, not essential.

Another possibility is for the pore to be provided with a first coating 94 as shown in Fig. 11C and for the hollow space 96 remaining in the coating 94 to be completely filled with another material 98. On removing the $Al_2O_3$ wall material around the pore by etching, a nano object 90" as shown in axial section in Fig. 11C then remains. Naturally, the solid bar-like object of Fig. 11C could also be provided with further coatings, if desired, by applying these coatings first to the inside of the pore and then removing the $Al_2O_3$ material around the pore. Alternatively, the pore itself could be first filled completely with solid materials, such as 98, and the nano object resulting, i.e. the nanobar 90" in Fig. 11C, then being coated in some way with one more external coatings (not shown but in principle equivalent to the interior coating 94 in Fig. 11C. In principle, it is also possible to form an article such as 90 shown in Fig. 11A and to coat the outside of this nanotube, providing that the nanotube can be adequately supported during the plating or deposition process (e.g. a PVD or CVD deposition process).

The series of drawings of Figs. 12A to 12C are closely similar to those of Figs. 11A to 11C, which is why the same reference numerals have been used, but just increased with the basic numeral 100 for the sake of easy distinction. It will be appreciated that unless something different is stated, the description given in relation to Figs. 11A to 11C and to possible modifications thereof also applies to the embodiment of Figs. 12A to 12C.

The most important point with regard to Figs. 12A to 12C is that here pores are used having first pore segments with a relatively narrow diameter (such as 84 in Fig. 8A) and second pore segments with a relatively larger diameter (such as 82 in Fig. 8A). These segments result in segments 200 and 202 of corresponding size in Figs. 12A to 12C. In the embodiment of the nanotube shown in Fig. 12A, the larger diameter portions 200 are present at each end of the nanotube and this can be convenient, for example for providing an inlet and an outlet to the nanotube for flow therethrough. In the middle of the nanotube there is also a section 200' of enlarged diameter which could, for example, serve as a reaction chamber allowing two chemicals supplied from one end a certain dwell time to react together before leaving the nanotube at the other end. The wall material of the nanopore could, for example, also consist of a material whose electrical resistance changes when in contact with gas or liquid molecules of a certain type. Such a tube could then be connected to a potential source at both ends and its resistance measured. The change in resistance could then serve for the detection of the gaseous species being sought.

The material of the wall or of the inner wall could also be a thin layer of a catalyst, so that the nanotube acts as a catalytic converter on a small scale.

As before, the nano object could also be filled with a material which subsequently solidifies to produce a nano object 190" as shown in Fig. 12C. In such an object, the different lengths of the wider diameter portions 200 and/or of the narrower diameter portions 202 could be varied to generate an object which could be likened to a barcode, but on a nanometre scale. Again, the outside of the nano object 190" of Fig. 12C, or indeed simply the core portion thereof if the pore was not coated prior to filling it, could be coated with one or more layers of one or more coatings to ensure specific properties of the device.

A whole variety of other designs are possible based on this basic concept. For example, it is not necessary for the nano object 190, 190', 190" of Figs. 12A and 12C to have three segments 200 of larger diameter. The number of segments 200 of larger diameter could range from one to a very larger number. In addition, there is no need for the segments 200 of larger diameter to have just one common diameter, different diameters could be selected by appropriate variation of the mild anodization conditions used to produce these segments. Also there is no significant restriction on the relative lengths of the segments 200 of larger diameter and the segments 202 of smaller diameter, particularly since the segments of smaller diameter can be produced very rapidly using the process of the present invention.

For many applications it is also not necessary to coat or fill the pores produced in the piece of aluminium and then remove the aluminium to leave the coated or filled pores, but rather the piece of aluminium with the coated or filled

EP 1 884 578 A1

pores can be used as it stands for an appropriate purpose. Thus, such coated pores could be used in a chemical reactor, for example for carrying out catalytic reactions, and pores with a solid filling could be used for specific photronic devices (as could also coated pores which are not solid). Naturally, the piece of aluminium provided with the nanoporous, self-ordered structure can also be used as it stands for certain applications, for example as a filter. If the pores produced need to be of a different size to obtain filtration in the desired range of sizes, then they can be coated to set the desired free cross-section of the respective pores.

Finally, Fig. 13 will be described in order to explain how a lithographically generated structure related to but different from the self-ordered array of pores can be used to enhance the regularity of the self-ordered array. For aluminium the pores of the self-ordered array are based on the centre points such as 220 of a hexagonal grid 222 as shown in broken lines in Fig. 13.

A lithographically generated structure such as exemplified by the diamond shaped full line grid 224 in Fig. 13 can be superimposed on the hexagonal array of points 220 such that corner points 226 of the diamond shaped array coincide with some of the centre points 220 of the hexagonal array 222. This results, e.g. as shown in Fig. 13, in a corner point 226 of the diamond grid coinciding with every second centre point 220 along horizontal lines such as 228 of the diamond shaped array and with every second centre point along the oblique grid lines 230 of the diamond shaped array.

Thus, an imprint tool can be used with protrusions at positions corresponding to the corner points 226 and will lithographically guide the formation of pores in a self-ordered manner at all the points 220. I.e. the periodicity of the lithographically generated structure (corner points 226) is related to that of the self-ordered array 222 (centre points 220) which arises without lithography such that dimensions of the array 222 are smaller than corresponding dimensions of the lithographically generated guiding structure 224 by a regular factor, in this case by the factor 2. Different factors are also possible, e.g. 3, 4 etc and need not be the same for each side of the lithographically generated guiding structure. It will be understood that the lithographically generated structure can be an imprint structure with projections at the corner points 226 or depressions or perturbations at the surface of the piece of aluminium caused by some other form of lithography. It will be noted that pores do not just form at points along the (imaginary) grid lines of the lithographically generated structure but also at the centres of the cells defined thereby.

## Claims

1. A method of manufacturing a self-ordered porous structure of $Al_2O_3$ with regularly spaced pores and regularly sized pores by inserting a piece of aluminium (12) as an anode in an electrolytic cell (10), the cell also comprising a cathode (28) and an electrolyte (22) and applying a potential difference between the anode and the cathode, with the electrolyte and the potential difference being selected to generate the desired self-ordered porous structure, **characterised in that** the electrolyte is selected to be oxalic acid and the potential difference is selected to be constant within the range 80V to 180V, especially within the range 110V to 150V.

2. A method in accordance with claim 1, wherein prior to generating the desired self-ordered porous structure a layer (72) of $Al_2O_3$ is formed on the piece of aluminium by anodization, said layer preferably having a thickness in the range from 100 nm upwards, but preferably not more than 10 $\mu$m in thickness.

3. A method in accordance with claim 1 or claim 2, wherein the current density is simultaneously controlled during the generation of the self-ordered porous structure to lie between 20 mA/cm$^2$ to 500 mA/cm$^2$ and preferably in the range from 100 to 200 mA/cm$^2$.

4. A method in accordance with claim 3, wherein the current density is kept constant.

5. A method in accordance with claim 3, wherein the current density is varied in accordance with a preset pattern.

6. A method in accordance with one of the claims 2 to 6, wherein the current density is regulated by regulating at least one of the molar concentration of the electrolyte, the temperature of the electrolyte and the temperature of the piece of aluminium.

7. A method in accordance with any one of the preceding claims, wherein the temperature of the electrolyte is selected to lie in the range -30°C to +80°C, optionally by adding an organic solvent to prevent freezing, such as an alcohol, for example ethanol, methanol, isopropanol, or an antifreeze such as ethylene glycol, or to lie in a temperature above 80°C by suppressing the boiling point of the electrolyte, for example by pressurization.

8. A method in accordance with any one of the preceding claims and comprising the further step of treating an $Al_2O_3$

layer 72 formed on the piece of aluminium lithographically to generate a regular periodic structure 74 at a surface of the $Al_2O_3$ layer with a periodicity matched to that of the self-ordered porous structure.

9. A method in accordance with claim 8, wherein the lithographic treatment step comprises one of an imprint step (70) to produce a periodic array of indentations (71') in either the $Al_2O_3$ layer or in a polymeric layer or photoresist layer provided on a surface of the $Al_2O_3$ layer, a soft imprint step as used in the manufacture of semiconductor chips, for example an S-FIL process; patterning of a photoresist layer, for example by photolithography, interference lithography, electronic beam lithography, focussed ion beam lithography or X-ray lithography, direct mask lithography, shadow mask lithography, for example by sputtering $Al_2O_3$ onto said surface through a shadow mask, and a print lithography, i.e. depositing a patterned layer by a printing technique.

10. A method in accordance with claim 8 or claim 9 in which the periodicity of the lithographically generated structure (224, 226) is related to that of a self-ordered array (222), which arises without lithography such that dimensions of the array (222) are smaller than corresponding dimensions of the lithographically generated structure (224, 226) by a geometrically defined factor, e.g. $D_{int}/3^{1/2}$; $D_{int}/9^{1/2}$; $D_{int}/27^{1/2}$ or $D_{int}/(3n^2)^{1/2}$ where n is an integer.

11. A method in accordance with any one of the claims 8 to 10 in which the self-ordered structure is guided lithographically to form with a periodicity related to, but smaller or larger within $\pm$ 25 % than that of the structure of lithographically defined periodicity.

12. A method in accordance with any one of the claims 8 to 11, wherein the self-ordered array (222) is a hexagonal array and the lithographically matched array (224) is a regular array having points (226) corresponding to at least some of the corner points (220) of the hexagonal self-ordered array, whereby pores arise not just at said corresponding points, but at geometrically defined intervals between said corresponding points.

13. A method in accordance with any one of the preceding claims 8 to 11, wherein said lithographically generated structure includes elongate structures, with pores being formed at at least each end of each elongate structure.

14. A method in accordance with any one of the preceding claims in which said piece of aluminium comprises an aluminium film deposited on, or formed on, or bonded to a substrate from the group comprising an insulating substrate, such as glass or silicon dioxide, and a semiconducting or conducting substrate, such as ITO (Indium Tin Oxide), or silicon, or doped silicon.

15. A method in accordance with claim 14, including the step of patterning the substrate lithographically to generate a regular periodic structure at the surface, with a periodicity matched to that of the self-ordered porous structure to produce patterning of the aluminium.

16. A method in accordance with claim 14 in which the substrate is removed from the piece of aluminium after patterning and prior to anodization.

17. A method in accordance with one of the preceding claims 8 to 16, wherein, after or prior to patterning of the piece of aluminium, a surface layer thereof is anodized prior to generation of the porous structure.

18. A method in accordance with one of the preceding claims, wherein, in addition to the step of generation of the self-ordered porous structure, one or more further anodization steps are carried out under different conditions to form pore segments of one or more different diameters at one or more positions along the length of each pore.

19. A method in accordance with claim 18, wherein said different conditions are selected to correspond with the self-ordered porous structure of the same pore spacing, for example by selecting at least one of a different electrolyte, a different potential difference, a different current density (for example by varying the temperature of the electrolyte or of the concentration of the electrolyte), and by selecting the same electrolyte and the same potential difference, and by varying the current density.

20. A method of manufacturing a self-ordered porous structure of $Al_2O_3$ with regularly spaced pores and regularly sized pores by inserting a piece of aluminium (12) as an anode in an electrolytic cell (10), the cell also comprising a cathode (28) and an electrolyte (22) and applying a potential difference between the anode and the cathode, with the electrolyte and the potential difference being selected to generate the desired self-ordered porous structure, **characterised by** the further step of treating the piece of aluminium (12) or an $Al_2O_3$ layer (72) formed on the piece of aluminium lithographically to generate a regular periodic structure (depressions 71') at a surface of the piece of aluminium or $Al_2O_3$ layer (72), with a periodicity matched to that of the self-ordered porous structure.

21. A method in accordance with claim 19, wherein the electrolyte and the potential difference are selected from at least one of the following group

- sulphuric acid as electrolyte with a potential difference in the range from 40V to 90V to generate an interpore separation of 90-140 nm
- oxalic acid as an electrolyte with a potential difference of approximately 40V to obtain an interpore separation of 100 nm
- phosphoric acid as an electrolyte with a potential difference of 150V to 400V to obtain an interpore separation of 405 to 500 nm
- oxalic acid as an electrolyte with a potential difference in the range from 80V to 180V to obtain an interpore separation of 150 to 400 nm.

22. A method in accordance with any one of the preceding claims, wherein the lithographically pre-patterned piece of aluminium or aluminium substrate is used with one of the following electrolytes:

- malonic acid from 1 mM to 5 M and 70 to 180 V potential
- sulphuric acid from 1 mM to 5 M and 30 to 70 V potential
- phosphoric acid from 1 mM to 5 M and 200 to 500 V potential, wherein the pre-patterning fits the pore structure; i.e. one pore per pre-patterned indentation, the interpore distance being in the range from 1.5 to 2.2 nm/V of the applied potential.

23. A method in accordance with any one of the preceding claims, comprising the further step of applying a coating (94, 96) to the walls of the porous structure to reduce the size of the pores.

24. A method in accordance with claim 23, wherein said step of applying a coating (94, 96) to the walls of the pores of the pore structure comprises one of an electroplating step, infiltration of the pores with a liquid polymer and curing said liquid polymer with radiation, ALD (Atomic Layer Deposition) from a gas phase precursor, a CVD process, electroless deposition, liquid phase deposition by use of a metal precursor, sol-gel coating, or layer-by-layer (LBL) assembly of a polyelectrolyte.

25. A method in accordance with either of claims 23 or 24, comprising the further step of removing the $Al_2O_3$ to leave the coating in the pores in the form of nanowires (90"; 190") or nanotubes (90; 90', 190; 190').

26. A method in accordance with claim 25, wherein said pores of said porous structure have portions (74, 78; 82, 84) of at least two different diameters so that the coating (194, 196) remaining as nanowires or nanotubes following the removal of the $Al_2O_3$ have correspondingly sized larger diameter and smaller diameter segments (200, 202).

27. Use of a self-ordered porous structure produced in accordance with any one of the preceding claims for at least one of the following purposes: magnetic data storage, as a detector, as a photronic device, as a filter, as a thermoelectric device, as a chemical reactor.

28. A nanoporous article in accordance with claim 27, in the form of a membrane obtained by forming a nanoporous alumina film on an aluminium substrate by anodization, subsequently removing the aluminium substrate and a barrier oxide layer sealing the nanoporous alumina film leaving a nanoporous alumina film with through-going channels.

29. A nanoporous article of $Al_2O_3$ having a self-ordered porous structure of $Al_2O_3$ with regularly spaced pores and regularly sized pores, **characterised in that** the interpore spacing lies in the range from 150 to 400 nm.

30. A nanoporous article in accordance with any one of the preceding claims, wherein each said pore has an aspect ratio being the ratio of the length of pores and the diameter of the pore of at least 50.

31. A nanoporous article in accordance with claim 29 or 30, wherein residual carbon atoms of at least 1 % by weight are included in the walls of the pores.

**32.** A nanoporous article in accordance with one of the preceding claims 29, 30 or 31, wherein each pore has at least one segment (74; 82) of larger diameter and at least one segment (78; 84) of smaller diameter, with a difference between the larger diameter and the smaller diameter being at least 10 nm.

**33.** A nanoporous article (90; 90'; 190; 190') in accordance with any one of the preceding claims and further comprising a layer (94; 94, 96; 194; 194, 196) generated by a coating formed on a wall of the or each pore.

**34.** A nano object (190'; 190") comprising at least first and second portions (200, 202) having different diameters in the range from 5 nm to 400 nm and an overall length of 200 nm to 1 mm or more, each portion having a length in the range from 100 nm to 50 $\mu$m.

**35.** A nano object in accordance with claim 34 and comprising one of a single material (94; 194), a multilayer nanotube (94, 96; 194, 196) or core shell and a coated nanotube or core shell optionally with a different coating layer composition in the radial direction, said nano object being utilisable by way of example as a chemical reactor for one or more materials in the gas phase and/or in the liquid phase, in a solar cell or as a transparent electrode.

**36.** A method in accordance with any one of the claims 1 to 20 and including the further steps of forming a nanoporous alumina film on an aluminium substrate by anodization, subsequently removing the aluminium substrate and a barrier oxide layer sealing the nanoporous alumina film leaving a nanoporous alumina film with through-going channels.

FIG. 1

FIG. 2

FIG. 3

FIG. 4

FIG. 5

FIG. 6

FIG. 7

FIG. 8

A

imprint mold

Al

(i) mild anodization

Al

(ii) hard anodization

Al

(i-ii)

Al

B    2 µm

C

D    10 µm

E

F

G

FIG. 9

FIG. 10

FIG 11 A

FIG 11 B

FIG 11 C

FIG 12 A

FIG 12 B

FIG 12 C

FIG. 13

European Patent Office

**EUROPEAN SEARCH REPORT**

Application Number

EP 06 01 5912

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2003/047505 A1 (GRIMES CRAIG A [US] ET AL) 13 March 2003 (2003-03-13) | 1-7, 14-19, 21,29-32 | INV. C25D11/10 C25D11/12 C25D11/16 |
| Y | * paragraph [0010] - paragraph [0018] * <br> * paragraph [0059] - paragraph [0062]; example 1 * <br><br> * claims 11,13-19 * | 8-13,20, 22-26, 33,36 | |
| Y | MIKULSKAS I ET AL: "ALUMINUM OXIDE PHOTONIC CRYSTALS GROWN BY A NEW HYBRID METHOD" <br> ADVANCED MATERIALS, WILEY VCH, WEINHEIM, DE, <br> vol. 13, no. 20, <br> 16 October 2001 (2001-10-16), pages 1574-1577, XP001129527 <br> ISSN: 0935-9648 <br> * figure 1d * | 8-13,20, 22 | |
| X | US 6 231 744 B1 (YING JACKIE Y [US] ET AL) 15 May 2001 (2001-05-15) <br><br> * column 11, line 23 - column 13, line 10; examples * <br> * column 6, line 7 - line 26 * <br> * column 13, line 45 - column 15, line 4 * | 1-7, 23-26, 29-33 | TECHNICAL FIELDS SEARCHED (IPC) <br><br> C25D |
| X | US 2005/255315 A1 (YAMANAKA SHINSUKE [JP] ET AL) 17 November 2005 (2005-11-17) <br> * paragraph [0054] * | 1,29 | |

-/--

The present search report has been drawn up for all claims

| Place of search | Date of completion of the search | Examiner |
|---|---|---|
| The Hague | 23 March 2007 | Desbois, Valérie |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.......................................................................

& : member of the same patent family, corresponding document

EPO FORM 1503 03.82 (P04C01)

**European Patent Office**

## EUROPEAN SEARCH REPORT

Application Number

EP 06 01 5912

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| D,X | S. Z. CHU, K. WADA, S. INOUE, M. ISOGAI, A. YASUMORI: "Fabrication of ideally ordered nanoporous alumina films and integrated alumina nanotubule arrays by high-field anodization" ADVANCED MATERIALS, vol. 17, 2005, pages 2115-2119, XP002411950 * the whole document * | 1-7, 14-19, 21,27, 29-32 | |
| A | EP 0 363 123 A (ALCAN INT LTD [CA]) 11 April 1990 (1990-04-11) * example 1 * | 1,5,18, 19,21 | |
| D,A | MASUDA H ET AL: "ORDERED METAL NANOHOLE ARRAYS MADE BY A TWO-STEP REPLICATION OF HONEYCOMB STRUCTURES OF ANODIC ALUMINA" SCIENCE, AMERICAN ASSOCIATION FOR THE ADVANCEMENT OF SCIENCE,, US, vol. 268, 9 June 1995 (1995-06-09), pages 1466-1468, XP000770000 ISSN: 0036-8075 * the whole document * | 1,27,29 | |
| X | EP 0 931 859 A1 (NIPPON TELEGRAPH & TELEPHONE [JP]) 28 July 1999 (1999-07-28) | 28 | TECHNICAL FIELDS SEARCHED (IPC) |
| Y | * paragraphs [0077] - [0085]; figure 7 * | 36 | |
| X | US 6 325 909 B1 (LI JING [CA] ET AL) 4 December 2001 (2001-12-04) | 34 | |
| Y | * claims 10,19 * | 23-26, 33,35 | |

-/--

The present search report has been drawn up for all claims

| Place of search | Date of completion of the search | Examiner |
|---|---|---|
| The Hague | 23 March 2007 | Desbois, Valérie |

EPO FORM 1503 03.82 (P04C01)

**European Patent Office**

**EUROPEAN SEARCH REPORT**

Application Number

EP 06 01 5912

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | KIM ET AL: "Encapsulation and polymerization of acetylene molecules inside a carbon nanotube" CHEMICAL PHYSICS LETTERS, NORTH-HOLLAND, AMSTERDAM, NL, vol. 415, no. 4-6, 11 November 2005 (2005-11-11), pages 279-282, XP005135799 ISSN: 0009-2614 * abstract * * page 281, paragraph 4.CONCLUSION * ----- | 35 | |

TECHNICAL FIELDS SEARCHED (IPC)

The present search report has been drawn up for all claims

| Place of search | Date of completion of the search | Examiner |
|---|---|---|
| The Hague | 23 March 2007 | Desbois, Valérie |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 1 884 578 A1**

European Patent
Office

Application Number

EP 06 01 5912

---

## CLAIMS INCURRING FEES

The present European patent application comprised at the time of filing more than ten claims.

☐ Only part of the claims have been paid within the prescribed time limit. The present European search report has been drawn up for the first ten claims and for those claims for which claims fees have been paid, namely claim(s):

☐ No claims fees have been paid within the prescribed time limit. The present European search report has been drawn up for the first ten claims.

---

## LACK OF UNITY OF INVENTION

The Search Division considers that the present European patent application does not comply with the requirements of unity of invention and relates to several inventions or groups of inventions, namely:

see sheet B

☒ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

**European Patent Office**

**LACK OF UNITY OF INVENTION**
**SHEET B**

Application Number

EP 06 01 5912

The Search Division considers that the present European patent application does not comply with the requirements of unity of invention and relates to several inventions or groups of inventions, namely:

1. claims: 1(partially), 2-22, 27, 29(partially), 30-32

    A method of manufacturing a self-ordered porous structure of Al2O3 with regularly spaced pores and regularly sized pores by inserting a piece of aluminium as an anode in an electrolytic cell , the cell also comprising a cathode and an oxalic acid electrolyte and applying a constant potential difference within the range 80V to 180V between the anode and the cathode, an adapting the parameters (temperature of the elelctrolyte, current density), and the pretreatment (pre-patterming of the aluminium substrate) to obtain the desired ordere porous structure. A nanoporous article of Al2O3 having an ordered porous structure and its uses inmagnetic data storage, as a detector, as a photronic device, as a filter, as a thermoelectric device, as a chemical reactor.

    ---

2. claims: 1 (partially), 23-26,27 (partially), 28, 29 (partially), 33-36

    A method of processing a porous alumina layer formed on an aluminium substrate in order to obtain a nano-object. The nano-object obtained therefrom and its uses.

    ---

**ANNEX TO THE EUROPEAN SEARCH REPORT
ON EUROPEAN PATENT APPLICATION NO.**

EP 06 01 5912

This annex lists the patent family members relating to the patent documents cited in the above-mentioned European search report.
The members are as contained in the European Patent Office EDP file on
The European Patent Office is in no way liable for these particulars which are merely given for the purpose of information.

23-03-2007

| Patent document cited in search report | | | Publication date | Patent family member(s) | | | Publication date |
|---|---|---|---|---|---|---|---|
| US 2003047505 | A1 | | 13-03-2003 | NONE | | | |
| US 6231744 | B1 | | 15-05-2001 | NONE | | | |
| US 2005255315 | A1 | | 17-11-2005 | AU | 2003289065 | A1 | 14-07-2004 |
| | | | | WO | 2004057064 | A1 | 08-07-2004 |
| EP 0363123 | A | | 11-04-1990 | AU | 614186 | B2 | 22-08-1991 |
| | | | | AU | 4238289 | A | 05-04-1990 |
| | | | | BR | 8905000 | A | 08-05-1990 |
| | | | | CA | 2000056 | A1 | 03-04-1990 |
| | | | | CN | 1041708 | A | 02-05-1990 |
| | | | | DK | 483589 | A | 04-04-1990 |
| | | | | JP | 2218422 | A | 31-08-1990 |
| | | | | NO | 893919 | A | 04-04-1990 |
| EP 0931859 | A1 | | 28-07-1999 | CN | 1222943 | A | 14-07-1999 |
| | | | | WO | 9809005 | A1 | 05-03-1998 |
| | | | | KR | 20000023742 | A | 25-04-2000 |
| | | | | US | 6139713 | A | 31-10-2000 |
| US 6325909 | B1 | | 04-12-2001 | NONE | | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **S. B. LEE et al.** *Science,* 2002, vol. 296, 2198
- **S. PARK ; J.-H. LIM ; S.-W. CHUNG ; C. A. MIRKIN.** *Science,* 2004, vol. 303, 348
- **N. I. KOVTYUKHOVA ; T. E. MALLOUK.** *Adv. Mater.,* 2005, vol. 17, 187
- **L. ZHI ; J. WU ; J. LI ; U. KOLB ; K. MÜLLEN.** *Angew. Chem. Int. Ed.,* 2005, vol. 44, 2120
- **I. MIKULSKAS ; S. JUODKAZIS ; R. TOMASIUMAS ; J. G. DUMAS.** *Adv. Mater.,* 2001, vol. 13, 1574
- **H. MASUDA ; K. FUKUDA.** *Science,* 1995, vol. 268, 1466
- **H. MASUDA ; F. HASEGWA ; S. ONO.** *J. Electrochem. Soc,* 1997, vol. 144, L127
- **A. P. LI ; F. MÜLLER ; A. BIRNER ; K. NIELSCH ; U. GÖSELE.** *J. Appl. Phys.,* 1998, vol. 84, 6023
- **F. LI ; L. ZHANG ; R. M. METZGER.** *Chem. Mater.,* 1998, vol. 10, 2470
- **H. MASUDA ; K. YADA ; A. OSAKA.** *Jpn. J. Appl. Phys.,* 1998, vol. 37, L1340
- **K. NIELSCH ; J. CHOI ; K. SCHWIRN ; R. B. WEHRSPOHN ; U. GÖSELE.** *Nano Lett.,* 2002, vol. 2, 677
- **S. ONO ; M. SAITO ; M. ISHIGURO ; H. ASOH.** *J. Electrochem. Soc,* 2004, vol. 151, B473
- **S. SHINGUBARA ; K. MORIMOTO ; H. SAKAUE ; T. TAKAHAGI.** *Electrochem. Solidstate Lett.,* 2004, vol. 7, E15
- **S. Z. CHU ; K. WADA ; S. INOUE ; M. ISOGAI ; A. YASUMORI.** *Adv. Mater.,* 2005, vol. 17, 2115
- **S. ONO ; M. SAITO ; H. ASOH.** *Electrochim. Acta,* 2005, vol. 51, 827
- **H. MASUDA et al.** *Adv. Mater,* 2001, vol. 13, 189
- **S. FOURNIER-BIDOZ ; V. KITAEV ; D. ROUTKEVITCH ; I. MANNERS ; G. A. OZIN.** *Adv. Mater.,* 2004, vol. 16, 2193
- **H. ASOH ; K. NISHIO ; M. NAKAO ; T. TAMAMURA ; H. MASUDA.** *J. Electrochem. Soc.,* 2001, vol. 148, B152
- **E. LICHTENBERGER-BAJZA ; A. DOMONY ; P. CSOKÁN.** *Werkst. u. Korr,* 1960, vol. 11, 701
- **P. CSOKÁN.** *Metalloberfl,* 1961, vol. 15, B49
- **P. CSOKÁN ; C. C. SC.** *Electroplat. Metal Fi.,* 1962, vol. 15, 75
- **J. P. O'SULLIVAN ; G. C. WOOD.** *Proc. R. Soc. London, Ser. A,* 1970, vol. 317, 511
- **KELLER, M ; S. HUNTER ; D. L. ROBINSON.** *J. Electrochem. Soc,* 1953, vol. 100, 411
- **K. EBIHARA ; H. TAKAHASHI ; M. NAGAYAMA.** *J. Met. Finish. Soc. Jpn.,* 1983, vol. 34, 548
- **F. KELLER ; M. S. HUNTER ; D. L. ROBINSON.** *J. Electrochem. Soc,* 1953, vol. 100, 411
- **M. S. HUNTER ; P. FOWLE.** *J. Electrochem. Soc,* 1954, vol. 101, 481
- **A. GÜNTHERSCHULZE ; H. BETZ.** *Z. Phys.,* 1934, vol. 92, 367
- **N. CABRERA ; N. F. MOTT.** *Rept. Prog. Phys.,* 1948, vol. 12, 163
- **V. P. PARKHUTIK ; V. I. SHERSHULSKY.** *J. Phys. D: Appl. Phys.,* 1992, vol. 25, 1258
- **O. JESSENSKY ; F. MÜLLER ; U. GÖSELE.** *Appl. Phys. Lett.,* 1998, vol. 72, 1173